Europäisches Patentamt

European Patent Office

Office européen des brevets

(11) Veröffentlichungsnummer: **0 242 591**

**A1**

# (12) EUROPÄISCHE PATENTANMELDUNG

(21) Anmeldenummer: 87104007.7

(22) Anmeldetag: 18.03.87

(51) Int. Cl.4: **H01S 3/02** , H01S 3/045 , H01S 3/096

(30) Priorität: 21.03.86 DE 3609712

(43) Veröffentlichungstag der Anmeldung:
28.10.87 Patentblatt 87/44

(84) Benannte Vertragsstaaten:
AT BE CH DE FR GB GR IT LI NL SE

(71) Anmelder: **Siemens Aktiengesellschaft Berlin und München**
**Wittelsbacherplatz 2**
**D-8000 München 2(DE)**

(72) Erfinder: **Elias, Holger, Dipl.-Ing.**
**Fritz-Baer-Strasse 6**
**D-8000 München 71(DE)**

(54) **Laserdiodensender.**

(57) Laserdiodensender enthalten neben Ansteuer- und Regelschaltungen ein mit diesen Schaltungen verbundenes Lasermodul, das in einem Gehäuse auf einem Peltier-Kühler montiert den Trägeraufbau mit der Laserdiode, einer Fotodiode und einem Thermistor enthält. Durch den Peltier-Kühler wird die Laserdiodentemperatur in relativ engen Grenzen eingestellt, so daß ein zusätzlicher Wärmefluß vom Gehäuse über die Anschlußdrähte der Laserdiode unerwünscht ist. Die elektrische Verbindung von den Anschlußdrähten zur Laserdiode erfolgt deshalb über vergleichsweise dünne Bonddrähte und gegebenenfalls Blechstreifen, deren Induktivität zusammen mit vorhandenen Kapazitäten einen unerwünschten Resonanzkreis ergibt. Bei digitalen Übertragungssignalen mit Bitraten von wenigstens einigen hundert Mbit/s wird deshalb entsprechend der Erfindung zusätzlich ein zum Ansteuerstrom für die Laserdiode gegenphasiger Kompensationsstrom über den Trägeraufbau geleitet und dadurch eine Anregung des parasitären Resonanzkreises verhindert.

FIG 1

## Laserdiodensender

Die Erfindung betrifft einen Laserdiodensender entsprechend dem Oberbegriff des Anspruchs 1.

Ein derartiger Laserdiodensender ist aus H.L.Althaus und G.Kuhn: "Laserdiodensender in Modulbauweise", telcom report 6 (1983), Beiheft "Nachrichtenübertragung mit Licht", Seiten 90 - 96 bekannt. Die Laserdiode ist dabei in einem Lasermodul auf einem teilweise metallischen Trägeraufbau aufgebracht und der Trägeraufbau großflächig über einen Peltier-Kühler am Gehäuse befestigt. Die heiße Seite des Peltier-Kühlers ist dabei dem Gehäuse zugewandt, während auf der kühlen Seite der Trägeraufbau montiert ist. Die Laserdiode ist einerseits mit einem Lichtwellenleiter und andererseits mit einer Monitor-Photodiode verbunden, die ein Steuersignal für die Ansteuer-und Regelschaltungen der Laserdiode liefert. Am Trägeraufbau ist weiterhin ein Thermistor befestigt, der ein Signal für die Temperaturreglung des Peltier-Kühlers erzeugt.

Der Wärmefluß im Lasermodul erfolgt von der Laserdiode über den Trägeraufbau zur kalten Seite des Peltier-Kühlers. Um unerwünschten Wärmefluß vom Gehäuse des Lasermoduls zur Laserdiode zu vermeiden, dienen als die elektrischen Verbindungen insbesondere · vergleichsweise · dünne Bonddrähte. Diese Bonddrähte wirken aufgrund ihrer Länge als Induktivität. Zusammen mit den Kapazitäten der Isolationsschichten zwischen Laserdiode auf der einen, Peltier-Element, Thermistor und Monitor-Fotodiode auf der anderen Seite ergeben sich Resonanzkreise, die durch ein Übertragungssignal mit Bitraten von wenigstens einigen hundert Mbit/s angeregt werden können und da durch Anstiegszeit und Überschwingen der das Übertragungssignal bildenden Impulse negativ beeinflussen können. Ein elektrisches Hochfrequenz-Ersatzschaltbild eines Lasermoduls enthält damit parallel zum Anschluß für den Modulationsstrom einen ersten Kondensator, über den sich eine Reihenschaltung aus der Anschlußinduktivität der Laserdiode, dem dynamischen Innenwiderstand und einer weiteren Anschlußinduktivität der Laserdiode gegen Masse ergibt. Außerdem ist mit dem dynamischen Innenwiderstand der Laserdiode die Parallelschaltung dreier RLC-Glieder verbunden, die die Einwirkungen des Peltier-Kühlers, der Monitor-Fotodiode und des Thermistors beschreiben. Jedes dieser Glieder enthält im Anschluß an einen Kondensator entsprechend der Kapazität der Isolierschicht zwischen der Laserdiode und dem jeweiligen Element eine Reihenschaltung aus der Impedanz des jeweiligen Elementes einer ersten Anschlußinduktivität und der äußeren Kapazität des entsprechenden Elementes gegen Masse darstellt. Dieser RLC-Schaltung ist jeweils ein LC-Glied parallel geschaltet, das die Auswirkung einer weiteren Anschlußinduktivität des Elementes und weiterer parasitärer Kapazitäten beschreibt. Ein vereinfachtes Ersatzschaltbild ergibt im Anschluß an eine Reihenschaltung aus einer ersten Anschlußinduktivität und dem dynamischen Innenwiderstand der Laserdiode einen mit Bezugspotential verbundenen Parallel-Resonanzkreis aus einer zweiten Anschlußinduktivität der Laserdiode und einer resultierenden Kapazität, die sich aus den Kapazitäten der einzelnen Isolierschichten zwischen Laserdiode und angeschlossenen Elementen ergibt. Dieser Parallelresonanzkreis ist durch eine Reaktanz bedämpft, die sich aus den Impedanzen der Elemente und der Impedanz der äußeren Beschaltung ergibt. Bei höherratigen Übertragungssigna len mit Bitraten von einigen hundert Mbit/s setzen sich die jeweiligen Signalimpulse aus Energieanteilen bei Frequenzen im GHz-Bereich zusammen, so daß wegen der kleinen Abmessungen des Lasermoduls mit relativ großen wirksamen Kapazitäten und dadurch mit einer entsprechend großen Rückwirkung gerechnet werden kann.

Die Aufgabe der Erfindung besteht also darin, einen Laserdiodensender der eingangs erwähnten Art so weiterzubilden, daß die sich wegen der Verwendung von Bonddrähten zwangsläufig bildenden Resonanzkreise die Anstiegszeit und das Überschwingen der Übertragungssignalimpulse auch bei höherratigen Übertragungssignalen nicht wesentlich negativ beeinflussen.

Erfindungsgemäß wird die Aufgabe durch einen Laserdiodensender gelöst, der durch die Merkmale entsprechend dem Kennzeichen des Patentanspruchs 1 weitergebildet ist. Zweckmäßige Ausbildungen des erfindungsgemäßen Laserdiodensenders sind in den Patentansprüchen 2 bis 5 näher erläutert.

Die Erfindung soll im folgenden anhand eines in der Zeichnung dargestellten Ausführungsbeispiels näher erläutert werden.

In der Zeichnung zeigt

Figur 1 einen erfindungsgemäßen Lasermodul,

Figur 2 das Hochfrequenzersatzschaltbild des Lasermoduls nach Figur 1 und

Figur 3 eine Ansteuerschaltung für den Lasermodul nach Figur 1.

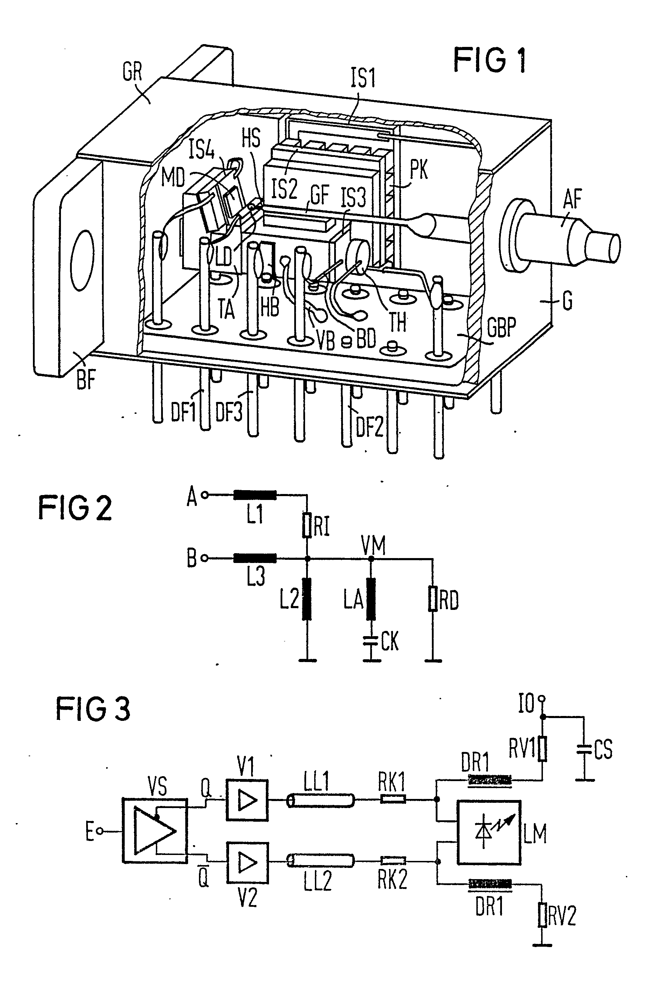

Der in der Figur 1 dargestellte Lasermodul geht aus von dem in der Einleitung erwähnten bekannten Lasermodul und enthält ein rechteckförmiges Gehäuse G, dessen eine Oberflächenseite zu einem Befestigungsflansch BF erweitert ist, während aus der gegenüberliegenden Seite ein Anschlußflansch AF für die Glasfaser eines optischen Übertragungskabels herausragt. Eine der Mantelflächen des Gehäuses wird durch eine die Durchführungen enthaltende Gehäusebodenplatte GBP gebildet, an der gegenüberliegenden Mantelfläche ist ein Gehäusedeckel GD befestigt. An einer der noch freien Mantelflächen des Gehäuses G oder bei einer anderen Ausführungsform auf der Gehäusebodenplatte ist im Innern über eine erste Isolierschicht IS1 ein Peltier-Kühler PK befestigt, auf dem, getrennt durch eine zweite Isolierschicht IS2, der metallische Trägeraufbau TA angeordnet ist. An dem Trägeraufbau ist über eine dritte Isolierschicht IS3 ein Thermistor TH angebracht, dessen einer elektrischer Anschluß über einen Bonddraht mit dem Gehäuseboden und dessen anderer Anschluß mit einer Durchführung verbunden ist. Weiterhin ist das getaperte Ende einer Glasfaser in einem Metallröhrchen auf dem Trägeraufbau so befestigt, daß es mit der auf einer Erhöhung des Trägeraufbaus TA angeordneten Laserdiode LD in gutem optischen Kontakt steht. Das andere Ende des Anschlußtapers ist mit dem Metallröhrchen in einem größeren Metallrohr befestigt, das im Gehäuseinneren in den Anschlußflansch AF geführt ist. Auf der dem Anschlußtaper gegenüberliegenden Seite der Laserdiode ist auf einer Ausbildung des Trägeraufbaus eine Monitor-Fotodiode MD über eine vierte Isolierschicht IS4 befestigt.

Zur Zuführung des Laserdiodenstroms ist ein Anschluß der Laserdiode über einen Bonddraht mit einer ersten Durchführung DF1 verbunden, eine weitere elektrische Verbindung besteht von der Laserdiode über die zur Befestigung dienende Halteschicht HS, den Trägeraufbau TA und das Halteblech HB zur dritten Durchführung DF3. Zusätzlich ist vom Trägeraufbau TA ein Verbindungsdraht VB zur Gehäusebodenplatte GBP in der Nähe einer zweiten Durchführung DF2 angebracht. Über diesen Verbindungsdraht und die zweite Durchführung wird ein dem Laserdiodenstrom gegenphasiger Kompensationsstrom eingespeist, der über den Trägeraufbau TA, das Halteblech HB und die dritte Durchführung DF3 fließt und durch die Kompensation des Laserdiodenvorstroms auf dem Trägeraufbau einen virtuellen Massepunkt erzeugt.

Das in der Figur 2 dargestellte vereinfachte Ersatzschaltbild für den Lasermodul nach Figur 2 enthält die Anschlüsse A,B für den Laserdiodenstrom bzw. den Kompensationsstrom. Der Anschluß A entspricht dem äußeren Ende der ersten Durchführung DF1, der Anschluß B dem äußeren Ende der dritten Durchführung DF3 und der Masseanschluß dem äußeren Ende der zweiten Durchführung DF2. Die Induktivitäten L1,L2 stellen die Anschlußinduktivitäten der Laserdiode dar, die im vorliegenden Fall bei etwa 8nH liegen. Beide Induktivitäten sind über den dynamischen Innenwiderstand RI verbunden, wobei der Verbindungspunkt zwischen dem Innenwiderstand und der zweiten Induktivität den virtuellen Massepunkt darstellt, der auf dem Trägeraufbau erzeugt werden soll. Mit dem Anschluß B für den Kompensationsstrom ist dieser virtuelle Massepunkt über eine dritte Induktivität L3 verbunden, die weitere Anschlußinduktivitäten zusammenfaßt. Im Ersatzschaltbild parallelgeschaltet zur zweiten Anschlußinduktivität L2 ist ein Serienresonanzkreis aus einer resultierenden Induktivität LA und einer resultierenden Kapazität CK, diesem ist eine Reaktanz RD parallelgeschaltet, die sich aus den Widerständen der Verbindungsdrähte sowie aus der äußeren Beschaltung, insbesondere den an den Peletier-Kühler, die Monitor-Fotodiode und den Thermistor angeschlossenen äußeren Elemente ergibt.

Es ist erkennbar, daß im Ersatzschaltbild ein Resonanzkreis dargestellt ist, der in einem breiten Frequenzbereich Resonanzen erzeugen könnte, würde nicht durch den über die dritte Induktivität L3 eingespeisten und zum Laserdiodenstrom gegenphasigen Kompensationsstrom eine Resonanzanregung unterdrückt.

In der Figur 3 ist ein Teil der Ansteuerschaltung für den Lasermodul LM dargestellt. An einen Eingang E für das Übertragungssignal ist ein Symmetrierverstärker VS angeschlossen, der an seinen Ausgängen Q, symmetrische, gegenphasige Ausgangssignale an nachgeschaltete lineare Verstärker V1, V2 abgibt. Die Ausgänge dieser Linearverstärker sind jeweils getrennt über ein erstes bzw. zweites Leiterstück L1, L2 aus einem 50 Ohm Koaxkabel und einem ersten bzw. zweiten Koppelwiderstand RK1, RK2 mit etwa 50 Ohm Widerstand mit den Eingängen des Lasermoduls LM verbunden. Der eine Eingang des Lasermoduls ist außerdem über eine erste Drossel D1 und eine ersten Vorwiderstand RV1 mit einer Quelle für den Laserdiodenvorstrom IO verbunden, außerdem ist an dem Anschluß dieser Quelle ein Siebkondenstor CS angeschlossen. Der Anschluß des Lasermoduls LM für den Kompensationsstrom, der gleichzeitig einen der Masseanschlüsse des Lasermoduls darstellt, ist aus Symmetriegründen über eine zweite Drossel DR2 und einen zweiten Vorwiderstand RV2 mit Bezugspotential verbunden. Es ist erkennbar, daß für die Erzeugung des Kompensationsstroms neben einem zweiten Linearverstärker V2 lediglich ein zweites Leiterstück L2 und ein zweiter Koppelwiderstand R2 benötigt werden, da die als Lasertreiberstufen verwendeten Verstärker in der Regel als begrenzende Differenzverstärker aufgebaut sind und die zweite Differenzverstärkerstufe nur mit einem weiteren Ausgangsanschluß verbunden werden muß, der dem Ausgang Q entspricht und an dem ein zum ersten Ausgangsanschluß gegenphasiges Ausgangssignal entnehmbar ist.

**Ansprüche**

1. Laserdiodensender mit Ansteuer-und Regelschaltungen und einem daran angeschlossenen Lasermodul, der eine an eine Glasfaser optisch angeschlossene Laserdiode enthält, die im Innern eines Gehäuses des Lasermoduls auf einem Trägeraufbau befestigt ist, wobei der Trägeraufbau großflächig über einen elektrisch isolierten Peltier-Kühler mit dem Gehäuse und kleinflächig über dünne Drähte und gegebenenfalls Blechstreifen mit im Gehäuse angeordneten Durchführungen verbunden ist, und daß der Lasermodul eine mit den Ansteuer-und Regelschaltungen für die Laserdiode verbundene Monitor-Fotodiode und einen Thermistor zur Regelung des Peltierkühlers enthält, **dadurch gekennzeichnet,** daß zur Zuführung des Laserdiodenstroms eine erste Verbindung von einer ersten Durchführung (DF1) zu einem ersten Anschluß der Laserdiode (LD) direkt und eine zweite Verbindung von einer zweiten Durchführung (DF2) zu einem zweiten Anschluß der Laserdiode über den Trägeraufbau geführt ist, daß zur Erzeugung eines virtuellen Massepunktes innerhalb des Lasermoduls zusätzlich eine dritte Verbindung zwischen einer dritten Durchführung (DF3) und einem vom Laserdiodenstrom durchflossenem Teil des Trägeraufbaus angeordnet ist und daß an die dritte Durchführung (DF3) eine Quelle für einen zum Laserdiodenstrom gegenphasigen Kompensationsstrom angeschlossen ist.

2. Laserdiodensender nach Anspruch 1, **dadurch gekennzeichnet,** daß sämtliche Verbindungen (DF1, DF2, DF3) als Bonddraht ausgeführt sind.

3. Laserdiodensender nach Anspruch 1, **dadurch gekennzeichnet,** daß es sich bei der Quelle für den Kompensationsstrom um einen Teil der Ansteuer-und Regelschaltungen der Laserdiode handelt.

4. Laserdiodensender nach Ansprüchen 1 oder 3, **dadurch gekennzeichnet,** daß es sich bei der Quelle für den Kompensationsstrom um eine Stufe eines Differenzverstärkers handelt, dessen andere Stufe als Treiberstufe für den Laserdiodenstrom dient.

## FIG 1

## FIG 2

## FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | TELCOM REPORT, Band 6, Beiheft "Nachrichtenübertragung mit Licht", 1983, Seiten 90-96, München, DE; H.L. Althaus et al.: "Lasersender in Modulbauweise" <br> * Seite 91, "Funktionen des Moduls" - Seite 93, linke Spalte, Zeile 4; Abbildungen 4,5 * | 1-3 | H 01 S 3/02 <br> H 01 S 3/045 <br> H 01 S 3/096 |
| | --- | | |
| A | US-A-4 399 541 (KOVATS et al.) <br> * Zusammenfassung; Abbildungen 1-3; Patentanspruch 1 * | 1-4 | |
| | --- | | |
| A | GB-A-2 081 963 (CANON K.K.) <br> * Abbildung 1; Zusammenfassung * | 1 | |
| | ----- | | |
| | | | RECHERCHIERTE SACHGEBIETE (Int. Cl.4) |
| | | | H 01 S 3/02 <br> H 01 S 3/045 <br> H 01 S 3/096 |

Der vorliegende Recherchenbericht wurde für alle Patentansprüche erstellt.

| Recherchenort | Abschlußdatum der Recherche | Prüfer |
|---|---|---|
| DEN HAAG | 10-07-1987 | FARNESE G.P. |